(19) Europäisches Patentamt
European Patent Office
Office européen des brevets

(11) **EP 4 580 051 A1**

(12) **EUROPEAN PATENT APPLICATION**

(43) Date of publication:
**02.07.2025 Bulletin 2025/27**

(21) Application number: **24189792.5**

(22) Date of filing: **19.07.2024**

(51) International Patent Classification (IPC):
*H03F 1/02* (2006.01)    *H03F 1/56* (2006.01)
*H03F 3/195* (2006.01)    *H03F 3/21* (2006.01)
*H03F 3/24* (2006.01)

(52) Cooperative Patent Classification (CPC):
**H03F 3/195; H03F 1/0288; H03F 1/565;
H03F 3/211; H03F 3/245;** H03F 2200/36;
H03F 2200/451

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **29.12.2023 CN 202311848748**

(71) Applicant: **Suzhou Watech Electronics Co., Ltd.
Suzhou, Jiangsu 215125 (CN)**

(72) Inventor: **YANG, Mengsu
Suzhou, 215125 (CN)**

(74) Representative: **Michalski Hüttermann & Partner
Patentanwälte mbB
Kaistraße 16A
40221 Düsseldorf (DE)**

(54) **RADIO FREQUENCY POWER AMPLIFIER AND WIRELESS SIGNAL TRANSMITTING SYSTEM**

(57) Disclosed are a radio frequency power amplifier and a wireless signal transmitting system. The radio frequency power amplifier includes a first amplifying branch, comprising a first transistor and a first output circuit; and a second amplifying branch, comprising a second transistor and a second output circuit, wherein the first output circuit comprises a line with an electrical length of 50 degrees to 90 degrees formed based on capacitors and inductors, and the second output circuit comprises a line with an electrical length of 120 degrees to 180 degrees formed based on capacitors and inductors.

Fig. 2

**Description**

TECHNICAL FIELD

The present disclosure relates to the radio technical field, more particularly to a radio frequency power amplifier and a wireless signal transmitting system.

BACKGROUND

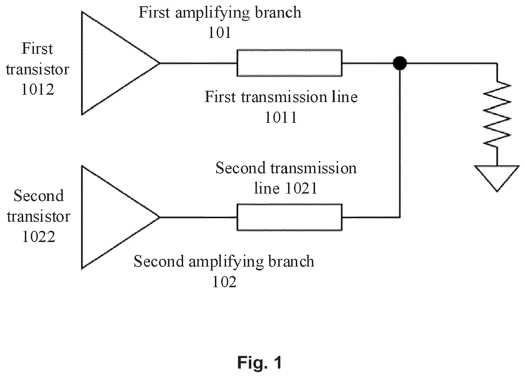

The radio frequency power amplifier is one of the most important components in the radio frequency front-end system. At present, the radio frequency power amplifier is widely used as the driver stage or last stage in base stations, and the radio frequency power amplifier is developing for the direction of high power, high efficiency, and miniaturization.
As shown in Fig. 1, Fig. 1 is a simplified circuit schematic diagram of a radio frequency power amplifier of prior art, the wideband topology of the radio frequency power amplifier can be based on a transmission line structure. The first amplifying branch 101 comprises a first transistor 1012 and a first transmission line 1011, the drain of the first transistor 1012 being connected to the first transmission line 1011, and the second amplifying branch 102 comprises a second transistor 1022 and a second transmission line 1021, the drain of the second transistor 1022 can be connected to the second transmission line 1021. The first transmission line 1011 can have an electrical length of 90 degrees, and the second transmission line 1021 can have an electrical length of 180 degrees. The radio frequency power amplifier has good bandwidth characteristics, but it needs a high-cost substrate or a large-area printed circuit board (PCB) to realize the structure of the transmission line, which is not conducive to miniaturization.

SUMMARY

In order to solve one of the above technical defects, the embodiment of the present disclosure provides a radio frequency power amplifier and a wireless signal transmitting system. The technical proposal is as follows:
According to a first aspect of an embodiment of the present disclosure, the present disclosure provides a radio frequency power amplifier, comprising:
a first amplifying branch comprising a first transistor and a first output circuit, a gate of the first transistor connected to a radio frequency output device, a drain of the first transistor being connected to a first end of the first output circuit, and a second end of the first output circuit connected to a signal transmitting device; and a second amplifying branch comprising a second transistor and a second output circuit, a gate of the second transistor being connected to the radio frequency output device, a drain of the second transistor being connected to a first end of the second output circuit, and a second end of the second output circuit being connected to the signal transmitting device; where the first output circuit comprises a line with an electrical length of 50 degrees to 90 degrees formed based on capacitors and inductors, and the second output circuit comprises a line with an electrical length of 120 degrees to 180 degrees formed based on capacitors and inductors.
According to a second aspect of the embodiment of the present disclosure, the present disclosure provides a wireless signal transmitting system, comprising:
a radio frequency output device and a signal transmitting device; and the mentioned radio frequency power amplifier respectively connected to the radio frequency output device and the signal transmitting device.
By adopting a radio frequency power amplifier provided in the embodiment of the present disclosure, the first amplifying branch with the first transistor can amplify the radio frequency signal outputted by the radio frequency output device, and the second amplifying branch with the second transistor can amplify the radio frequency signal outputted by the radio frequency output device. The amplified radio frequency signal passes through the first output circuit with an electrical length of 50 degrees to 90 degrees and the second output circuit with an electrical length of 120 degrees to 180 degrees to obtain good wideband characteristics and meet the requirements of the large wideband. Also, the first output circuit and the second output circuit are formed based on the inductor and the capacitor. Due to the characteristics of the inductor and the capacitor, it is not necessary to use the high-cost substrate or the large-area printed circuit board to realize the structure of the transmission line, and the cost and size of the radio frequency power amplifier can be reduced.

BRIEF DESCRIPTION OF THE DRAWINGS

The accompanying drawings described herein are used to provide further understanding of the disclosure and form part of the disclosure, and the illustrative embodiments of the disclosure and their explanations are used to explain the disclosure and do not constitute an undue qualification of the disclosure. In the drawings:

Fig. 1 is a simplified circuit schematic diagram of a radio frequency power amplifier of the prior art.
Fig. 2 is a simplified circuit schematic diagram of a radio frequency power amplifier of the present disclosure.

Fig. 3 is a circuit diagram of the radio frequency power amplifier corresponding to Fig. 2.
Fig. 4 is another circuit diagram of the radio frequency power amplifier corresponding to Fig. 2.
Fig. 5 is yet another circuit diagram of the radio frequency power amplifier corresponding to Fig. 2.
Fig. 6 is another simplified circuit schematic diagram of the radio frequency power amplifier of the present disclosure.
Fig. 7 is a circuit diagram of the radio frequency power amplifier corresponding to Fig. 6.
Fig. 8 is another circuit diagram of the radio frequency power amplifier corresponding to Fig. 6.
Fig. 9 is yet another circuit diagram of the radio frequency power amplifier corresponding to Fig. 6.
Fig. 10 is a simulation data diagram of the power amplifier corresponding to Fig. 6.
Fig. 11 is another simulation data diagram of the power amplifier corresponding to Fig. 6.
Fig. 12 is yet another simulation data diagram of the power amplifier corresponding to Fig. 6.

## DETAILED DESCRIPTION OF THE EMBODIMENT

In order to make the technical proposal and advantages of the embodiments of the present disclosure clearer, the following exemplary embodiments of the present disclosure will be described in further detail in conjunction with the accompanying drawings. Obviously, the described embodiments are only a part of the embodiments of the present disclosure, not an exhaustive list of all embodiments. It should be noted that the embodiments of the present disclosure and the features of the embodiments can be combined with each other without conflict.

As one of the core components of wireless signal transmitting systems, radio frequency power amplifiers are increasingly developing towards high power, high efficiency, and miniaturization. As shown in Fig. 1, the radio frequency power amplifier comprises a first amplifying branch 101 comprising a first transistor 1012 and a first transmission line 1011 connected to a drain of the first transistor 1012, and a second amplifying branch 102 comprising a second transistor 1022 and a second transmission line 1021 connected to a drain of the second transistor 1022. For example, the radio frequency power amplifier has an anti-Doherty structure formed by the first transmission line 1011 as the microstrip line forming an electrical length of 90-degree delay and the second transmission line 1021 as a microstrip line forming an electrical length of 180-degree delay. The radio frequency power amplifier has good wideband characteristics and can meet the needs of 5G and other large wideband, but it needs to use high-cost substrates or large-area printed circuit boards (PCBs) to realize the structure of the transmission line, which is not conducive to miniaturization.

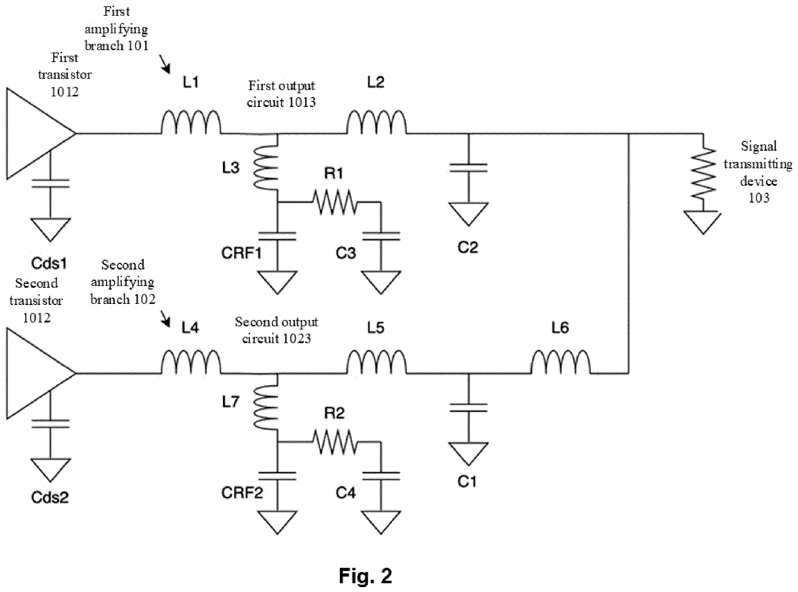

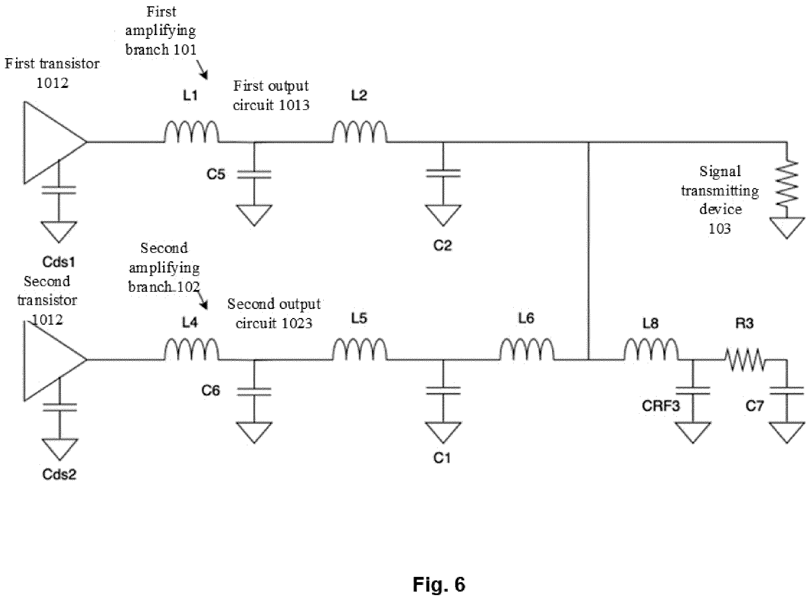

The present disclosure provides a radio frequency power amplifier, as shown in Figs. 2 and 6, Fig. 2 is a simplified circuit schematic diagram of the radio frequency power amplifier of the present disclosure, and Fig. 6 is another simplified circuit schematic diagram of the radio frequency power amplifier of the present disclosure. The radio frequency power amplifier comprises a first amplifying branch 101 comprising a first transistor 1012 and a first output circuit 1013, and a second amplifying branch 102 comprising a second transistor 1022 and a second output circuit 1023.

A gate of the first transistor 1012 can be connected to a radio frequency output device (not shown), a drain of the first transistor 1012 can be connected to a first end of the first output circuit 1013, and a second end of the first output circuit 1013 can be connected to a signal transmitting device 103. A gate of the second transistor 1022 can be connected to the radio frequency output device (not shown), a drain of the second transistor 1022 can be connected to a first end of the second output circuit 1023, and a second end of the second output circuit 1023 can be connected to the signal transmitting device 103. The radio frequency output device can output a radio frequency signal to the first transistor 1012 and the second transistor 1022. After the radio frequency signal is amplified through the first transistor 1012 and the second transistor 1022, the radio frequency signal is transmitted from the drain of the first transistor 1012 to the first output circuit 1013, from the drain of the second transistor 1022 to the second output circuit 1023, and then from the first output circuit 1013 and the second output circuit 1023 to the signal transmitting device 103 respectively, and is transmitted to the user terminal by the signal transmitting device 103.

The first output circuit 1013 can be a line having an electrical length of 50 degrees to 90 degrees formed by capacitor and inductor, i.e. the electrical length of the first output circuit 1013 comprises, but is not limited to, 55 degrees, 60 degrees, 65 degrees, 70 degrees, 73 degrees, 75 degrees, 80 degrees, 85 degrees, and 88 degrees. The second output circuit 1023 can be a line having an electrical length of 120 degrees to 180 degrees formed by capacitor and inductor, i.e. the electrical length of the second output circuit 1023 comprises, but is not limited to, 125 degrees, 130 degrees, 150 degrees, 155 degrees, 160 degrees, 165 degrees, 170 degrees, 175 degrees, and 177 degrees.

In the embodiment, the first amplifying branch with the first transistor can amplify the radio frequency signal outputted by the radio frequency output device, and the second amplifying branch with the second transistor can amplify the radio frequency signal outputted by the radio frequency output device. The amplified radio frequency signal passes through the first output circuit with an electrical length of 50 degrees to 90 degrees and the second output circuit with an electrical length of 120 degrees to 180 degrees to obtain good wideband characteristics and meet the requirements of the large wideband. Also, the first output circuit and the second output circuit are formed based on the inductor and the capacitor. Due to the characteristics of the inductor and the capacitor, it has a higher integration level, and may not be necessary to use the high-cost substrate or the large-area printed circuit board to realize the structure of the transmission line, and the cost and size of the radio frequency power amplifier can be reduced.

In one or more embodiments, as shown in Fig. 2, the first output circuit 1013 comprises a first inductor L1, a second inductor L2, a third inductor L3, a first decoupling capacitor CRF1, and a second capacitor C2. The first end of the first inductor L1 is connected to the drain of the first transistor 1012, the first end of the second inductor L2 is connected to the second end of the first inductor L1, the second end of the second inductor L2 can be connected to the signal transmitting device 103, the first end of the third inductor L3 is connected between the second end of the first inductor L1 and the first end of the second inductor L2, the second end of the third inductor L3 is connected to the first end of the first decoupling capacitor CRF1, and the second end of the first decoupling capacitor CRF1 is grounded. The first end of the second capacitor C2 is connected to the second end of the second inductor L2, and the second end of the second capacitor C2 is grounded. That is the first transistor 1011, the first inductor L1, and the second inductor L2 are sequentially connected in series, the third inductor L3 and the first decoupling capacitor CRF1 are connected in series, one end of the third inductor L3 opposite to the first decoupling capacitor CRF1 is connected between the first inductor L1 and the second inductor L2, and the one end of the first decoupling capacitor CRF1 opposite to the third inductor L3 is grounded. The first end of the second capacitor C2 is connected between the second end of the second inductor L2 and the signal transmitting device 103, and the second end of the second capacitor C2 is grounded.

The second output circuit 1023 comprises a fourth inductor L4, a fifth inductor L5, a sixth inductor L6, a seventh inductor L7, a second decoupling capacitor CRF2, and a first capacitor C1. The first end of the fourth inductor L4 is connected to the drain of the second transistor 1022, the second end of the fourth inductor L4 is connected to the first end of the fifth inductor L5, the second end of the fifth inductor L5 is connected to the first end of the sixth inductor L6, and the second end of the sixth inductor L6 is connected to the signal transmitting device 103. The first end of the seventh inductor L7 is connected between the second end of the fourth inductor L4 and the first end of the fifth inductor L5, the second end of the seventh inductor L7 is connected to the first end of the second decoupling capacitor CRF2, and the second end of the second decoupling capacitor CRF2 is grounded. The first end of the first capacitor C1 is connected between the second end of the fifth inductor L5 and the first end of the sixth inductor L6, and the second end of the first capacitor C1 is grounded. That is the second transistor 1022, the fourth inductor L4, the fifth inductor L5 and the sixth inductor L6 are sequentially connected in series, the seventh inductor L7 and the second decoupling capacitor CRF2 are connected in series, one end of the seventh inductor L7 away from the second decoupling capacitor CRF2 is connected between the fourth inductor L4 and the fifth inductor L5, and one end of the second decoupling capacitor CRF2 away from the seventh inductor L7 is grounded. One end of the first capacitor C1 is connected between the fifth inductor L5 and the sixth inductor L6, and the other end of the first capacitor C1 is grounded.

The first transistor 1012 has a first parasitic capacitor Cds1. In the first amplifying branch 101, the first parasitic capacitor Cds1, the first inductor L1, the second inductor L2, the third inductor L3, the first decoupling capacitor CRF1, and the second capacitor C2 can form a line having an electrical length of 50 degrees to 90 degrees. The second transistor 1022 has a second parasitic capacitor Cds2, In the second amplifying branch 102, the second parasitic capacitor Cds2, the fourth inductor L4, the fifth inductor L5, the sixth inductor L6, the seventh inductor L7, the second decoupling capacitor CRF2, and the first capacitor C1 can form a line having an electrical length of 120 degrees to 180 degrees. Thereby, not only good wideband characteristics are obtained to meet the demand of large wideband, but also the cost and size of the radio frequency power amplifier can be reduced. Further, by connecting the third inductor L3, and the seventh inductor L7 to the ground, the video bandwidth of the radio frequency power amplifier is increased.

In one or more embodiments, the first output circuit 1013 further comprises a first resistor R1, and a third capacitor C3. The first end of the first resistor R1 is connected between the second end of the third inductor L3 and the first end of the first decoupling capacitor CRF1, the second end of the first resistor R1 is connected to the first end of the third capacitor C3, and the second end of the third capacitor C3 is grounded. The second output circuit further comprises a second resistor R2 and a fourth capacitor C4. The first end of the second resistor R2 is connected between the second end of the seventh inductor L7 and the first end of the second decoupling capacitor CRF2, the second end of the second resistor R2 is connected to the first end of the fourth capacitor C4, and the second end of the fourth capacitor C4 is grounded.

The formation of video bandwidth (VBW) mainly depends on the resonance point formed at low frequency by the sum of the equivalent capacitance and the sum of the equivalent inductance calculated from the drain of the first transistor. Generally, the sum of the equivalent capacitance is determined by the third capacitor C3, and the fourth capacitor C4. Generally, it can be defaulted to the microfarad ($\mu$F) level, so the main determining factor is the equivalent inductance. Therefore, it is necessary to minimize the equivalent inductance by increasing the number of inductors paralleled and grounded, thereby increasing the video bandwidth. In order to prevent the resonance point amplitude from being too large, the first resistor R1 and the second resistor R2 are introduced to suppress the resonance amplitude.

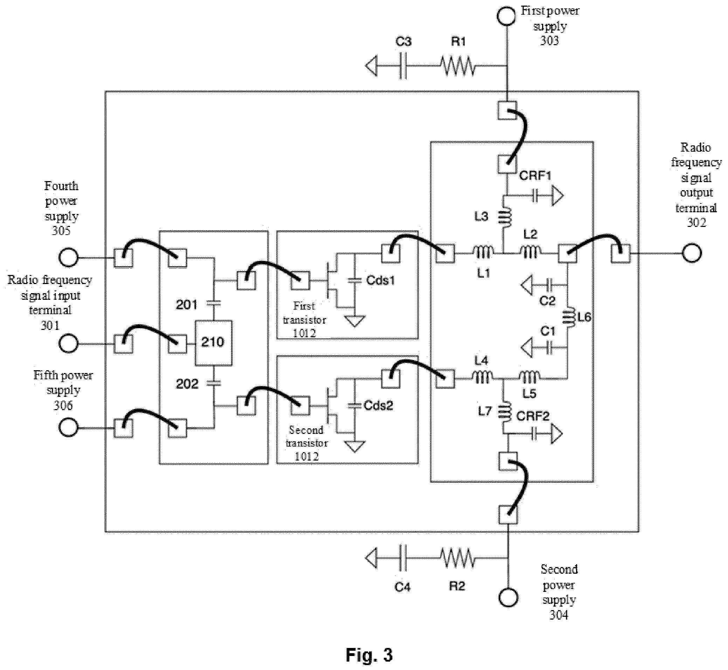

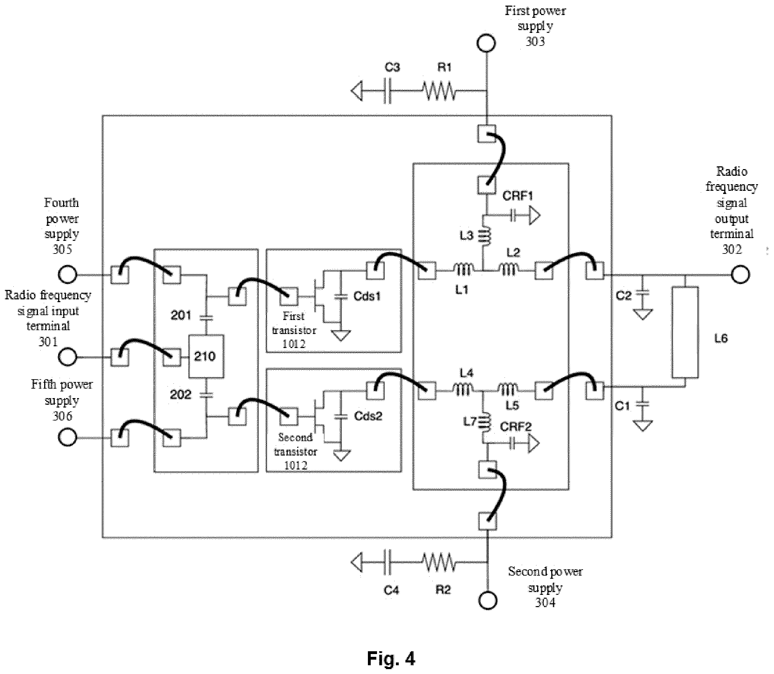

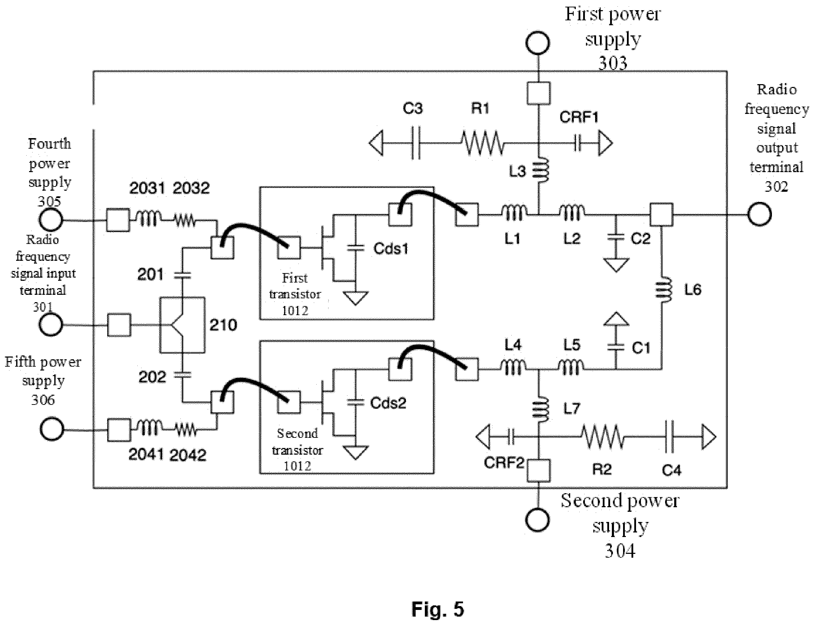

As shown in Figs. 3 to 5, Fig. 3 is a circuit diagram of the radio frequency power amplifier corresponding to Fig. 2, Fig. 4 is another circuit diagram of the radio frequency power amplifier corresponding to Fig. 2, and Fig. 5 is yet another circuit diagram of the radio frequency power amplifier corresponding to Fig. 2. In Fig. 3, most parts of the first output circuit and the second output circuit are implemented by one integrated passive device (IPD), on which capacitors, inductors, and the like are integrated, and are interconnected to the active chip and package pins through a bondwire. The first resistor R1 and the third capacitor C3, the second resistor R2 and the fourth capacitor C4 are implemented by surface-mounted components on a printed circuit board (PCB) outside the package. In Fig. 4, the part of the first output circuit and the second output circuit are implemented by one integrated passive device (IPD), on which capacitors, inductors, and the like are integrated, and are interconnected to the active chip and package pins through a bondwire. The part of the second amplifying branch is implemented by wiring and surface-mounted capacitors on the PCB board outside the package. In Fig. 5, the first output circuit and the second output circuit are completely implemented in one package, and the package can be LGA (Land Grid Array), on which components such as surface-mounted capacitors, surface-mounted inductors, and surface-mounted resistors are integrated and interconnected to the active chip through a bondwire, and interconnected to the package pin through a via.

In one or more embodiments, as shown in Figs. 3 to 5, the radio frequency power amplifier further comprises a first drain power supply circuit and a second drain power supply circuit. The first end of the first drain power supply circuit is connected between the first end of the third inductor L3, the first decoupling capacitor CRF1, and the second end of the first drain power supply circuit is connected to the first power supply 303. The first end of the second drain power supply circuit is connected between the second end of the seventh inductor L7 and the first end of the second decoupling capacitor CRF2, and the second end of the second drain power supply circuit is connected to the second power supply 304.

In one or more embodiments, as shown in Fig. 6, the first amplifying branch 101 further comprises a first inductor L1, a second inductor L2, a fifth capacitor C5, and a second capacitor C2. The first end of the first inductor L1 is connected to the drain of the first transistor 1012, the second end of the first inductor L1 is connected to the first end of the second inductor L2, the second end of the second inductor L2 is connected to the signal transmitting device 103, the first end of the fifth capacitor C5 is connected between the second end of the first inductor L1 and the first end of the second inductor L2, and the second end of the fifth capacitor C5 is grounded. The first end of the second capacitor C2 is connected to the second end of the second inductor L2, and the second end of the second capacitor C2 is grounded. That is, the first transistor 1011, the first inductor L1, and the second inductor L2 are sequentially connected in series. One end of the fifth capacitor C5 is connected between the first inductor L1 and the second inductor L2, and the other end of the fifth capacitor C5 is grounded. The first end of the second capacitor C2 is connected between the second end of the second inductor L2 and the signal transmitting device 103, and the second end of the second capacitor C2 is grounded.

The second output circuit 1023 comprises a fourth inductor L4, a fifth inductor L5, a sixth inductor L6, a sixth capacitor C6, and a first capacitor C1. The first end of the fourth inductor L4 is connected to the drain of the second transistor 1022, the second end of the fourth inductor L4 is connected to the first end of the fifth inductor L5, the second end of the fifth inductor L5 is connected to the first end of the sixth inductor L6, the second end of the sixth inductor L6 can be connected to the signal transmitting device 103, the first end of the sixth capacitor C6 is connected between the second end of the fourth inductor L4 and the first end of the fifth inductor L5, and the second end of the sixth capacitor C6 is grounded. The first end of the first capacitor C1 is connected between the second end of the fifth inductor L5 and the first end of the sixth inductor L6, and the second end of the first capacitor C1 is grounded. That is, the second transistor 1022, the fourth inductor L4, the fifth inductor L5, and the sixth inductor L6 are sequentially connected in series. One end of the sixth capacitor C6 is connected between the fourth inductor L4 and the fifth inductor L5, and the other end of the sixth capacitor C6 is grounded. One end of the first capacitor C1 is connected between the fifth inductor L5 and the sixth inductor L6, and the other end of the first capacitor C1 is grounded.

The first transistor 1012 has a first parasitic capacitor Cds1. In the first amplifying branch 101, the first parasitic capacitor Cds1, the first inductor L1, the second inductor L2, the fifth capacitor C5, and the second capacitor C2 can form a line having an electrical length of 50 degrees to 90 degrees. The second transistor 1022 has a second parasitic capacitor Cds2. In the second amplifying branch 102, the second parasitic capacitor Cds2, the fourth inductor L4, the fifth inductor L5, the sixth inductor L6, the sixth capacitor C6, and the first capacitor C1 can form a line having an electrical length of 120 degrees to 180 degrees. Thereby, not only good wideband characteristics are obtained to meet the demand of large wideband, but also the cost and size of the radio frequency power amplifier can be reduced.

In one or more embodiments, the radio frequency power amplifier further comprises an eighth inductor L8, a third resistor R3, a third decoupling capacitor CRF3, and a seventh capacitor C7, the first end of the eighth inductor L8 being connected to the second end of the second inductor L2 and the second end of the sixth inductor L6 respectively, the second end of the eighth inductor L8 being connected to the first end of the third resistor R3, the second end of the third resistor R3 being connected to the first end of the seventh capacitor C7, the second end of the seventh capacitor C7 being grounded, the first end of the third decoupling capacitor CRF3 being connected between the second end of the eighth inductor L8 and the first end of the third resistor R3 being grounded, and the second end of the third decoupling capacitor CRF3 being grounded.

The eighth inductor L8 is connected to the ground, and the video bandwidth of the radio frequency power amplifier is increased. Also, in order to avoid the amplitude of the resonance point being too large, the third resistor R3 is introduced to suppress the resonance amplitude.

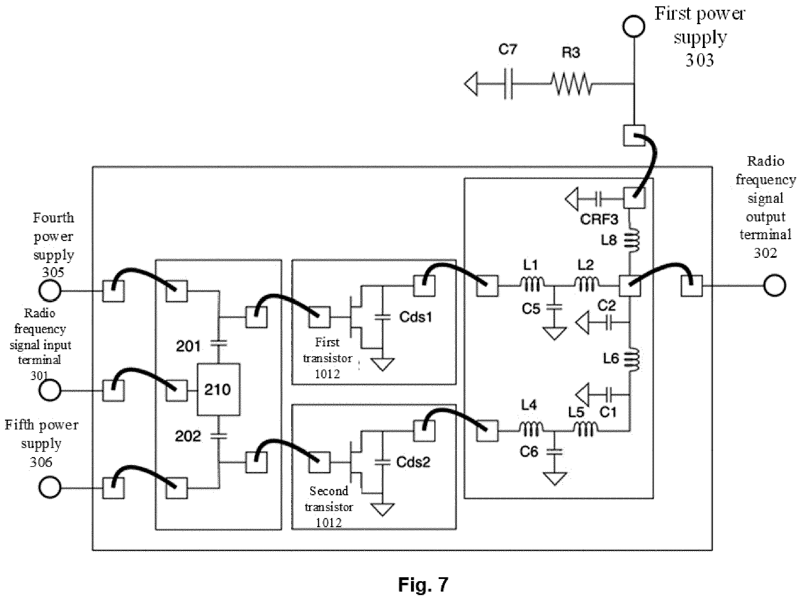

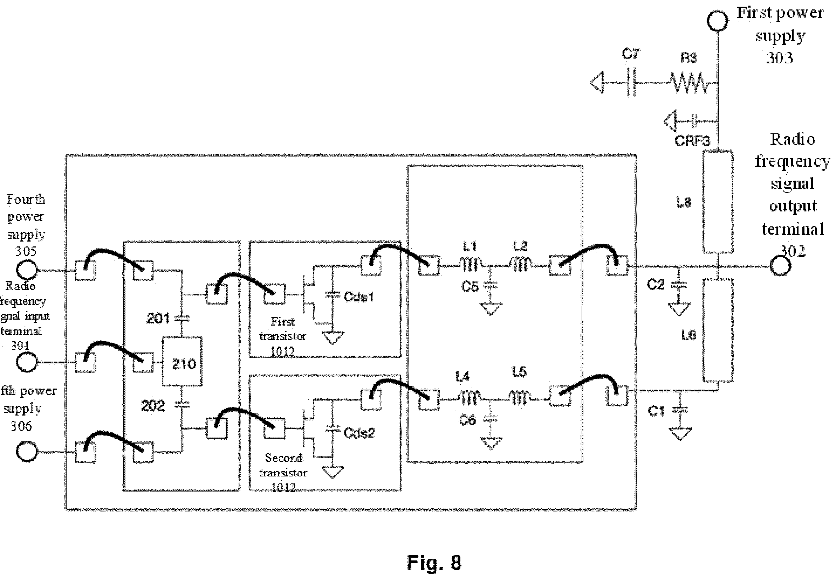

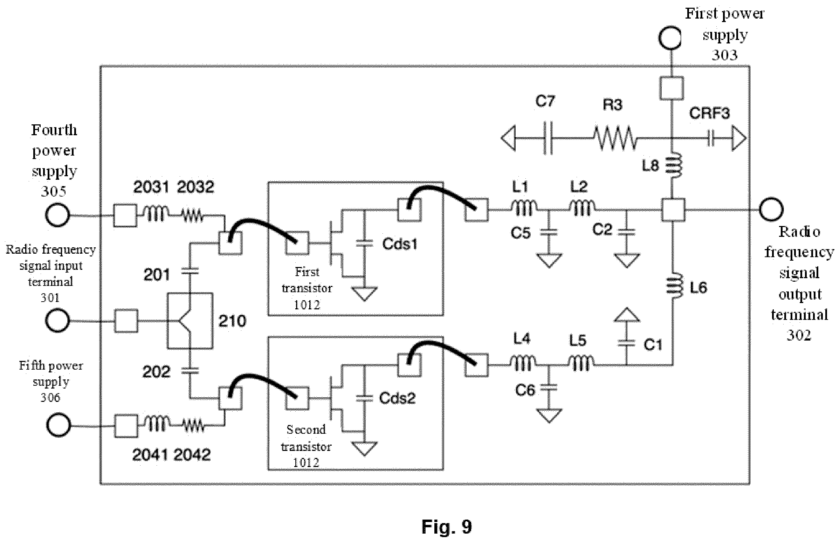

As shown in Figs. 7 to 9, Fig. 7 is a circuit diagram of the radio frequency power amplifier corresponding to Fig. 6, Fig. 8 is another circuit diagram of the radio frequency power amplifier corresponding to Fig. 6, and Fig. 9 is yet another circuit diagram of the radio frequency power amplifier corresponding to Fig. 6. In Fig. 7, the most parts of the first output circuit and the second output circuit are implemented by one integrated passive device (IPD), on which capacitors, inductors, and the like are integrated, and are interconnected to the active chip and package pins through a bondwire. The first resistor R1 and the third capacitor C3, the second resistor R2 and the fourth capacitor C4 are implemented by surface-mounted components on the PCB board outside the package. In Fig. 8, the part of the first output circuit and the second output circuit are implemented by one integrated passive device (IPD), on which capacitors, inductors, and the like are integrated, and are interconnected to the active chip and package pins through a bondwire. The part of the second amplifying branch is implemented by wiring and surface-mounted capacitors on the PCB board outside the package. In Fig. 9, the first output circuit and the second output circuit are completely implemented in one package, and the package can be LGA, on which components such as surface-mounted capacitors, surface-mounted inductors, and surface-mounted resistors are integrated, and are interconnected to the active chip through a bondwire, and interconnected to the package pin through a via.

In one or more embodiments, as shown in Figs. 7 to 9, the radio frequency power amplifier further comprises a third drain power supply circuit. The first end of the third drain power supply circuit is connected between the second end of the eighth inductor L8 and the first end of the third resistor R3, and the second end of the third drain power supply circuit is connected to the third power supply 307. The third power supply 307 supplies power to the drain of the first transistor 1012 and the drain of the second transistor 1022 through the third drain power supply circuit.

In one or more embodiments, as shown in Figs. 3 to 5 and 7 to 9, the radio frequency power amplifier can further comprise a power distributor 210, the input terminal of the power distributor 210 being connected to the radio frequency output device, the first output terminal of the power distributor 210 being connected to the gate of the first transistor 1012, and the second output terminal of the power distributor 210 being connected to the gate of the second transistor 1022. The radio frequency output device can be connected to the radio frequency signal input terminal 301, and after outputting the radio frequency signal, the radio frequency signal is divided at the power distributor 210 to transmit the radio frequency signal to the first amplifying branch and the second amplifying branch, so that the radio frequency signal is processed at the first amplifying branch and the second amplifying branch, so that the radio frequency signal is output to the signal transmitting device 103 at the radio frequency signal output terminal 302. The source of the first transistor 1012 is grounded, and the source of the second transistor 1022 is grounded.

In one or more embodiments, as shown in Figs. 3 to 5 and 7 to 9, the radio frequency power amplifier further comprises a first gate bias circuit and a second gate bias circuit. The first end of the first gate bias circuit is connected to the gate of the first transistor 1012 and the second end of the first gate bias circuit is connected to the fourth power supply 305. The first end of the second gate bias circuit is connected to the gate of the second transistor 1022, and the second end of the second gate bias circuit is connected to the fifth power supply 306. The fourth power supply 305 can supply voltage to the gate of the first transistor 1012 through the first gate bias circuit, and the fifth power supply 306 can supply voltage to the gate of the second transistor 1022 through the second gate bias circuit.

In one or more embodiments, as shown in Figs. 3 to 5 and 7 to 9, the radio frequency power amplifier further comprises a first DC-blocking capacitor 201 and a second DC-blocking capacitor 202. The first end of the first DC-blocking capacitor 201 is connected to the first output terminal of the power distributor 210, and the second end of the first DC-blocking capacitor 201 is connected to the gate of the first transistor 1012 and the first end of the first gate bias circuit respectively. The first end of the second DC-blocking capacitor 202 is connected to the second output terminal of the power distributor 210, and the second end of the second DC-blocking capacitor 202 is connected to the gate of the second transistor 1022 and the first end of the second gate bias circuit respectively. Since the fourth power supply 305 supplies power to the gate of the first transistor 1012, and the fifth power supply 306 supplies power to the gate of the second transistor 1022, confusion may occur through the power distributor 210, and the isolation of different gate voltages can be implemented by providing the first DC-blocking capacitor 201 and/or the second DC-blocking capacitor 202.

In one or more embodiments, as shown in Figs. 5 and 9, the first gate bias circuit comprises a ninth inductor 2031 and a fourth resistance 2032, one end of the ninth inductor 2031 being connected to the fourth power source 305, the other end of the ninth inductor 2031 being connected to one end of the fourth resistance 2032, and the other end of the fourth resistance 2032 being connected to the gate of the first transistor 1012. The second gate bias circuit comprises a tenth inductor 2041 and a fifth resistor 2042, one end of the tenth inductor 2041 being connected to the fifth power supply 306, the other end of the tenth inductor 2041 being connected to one end of the fifth resistor 2042, and the other end of the fifth resistor 2042 being connected to the gate of the second transistor 1022.

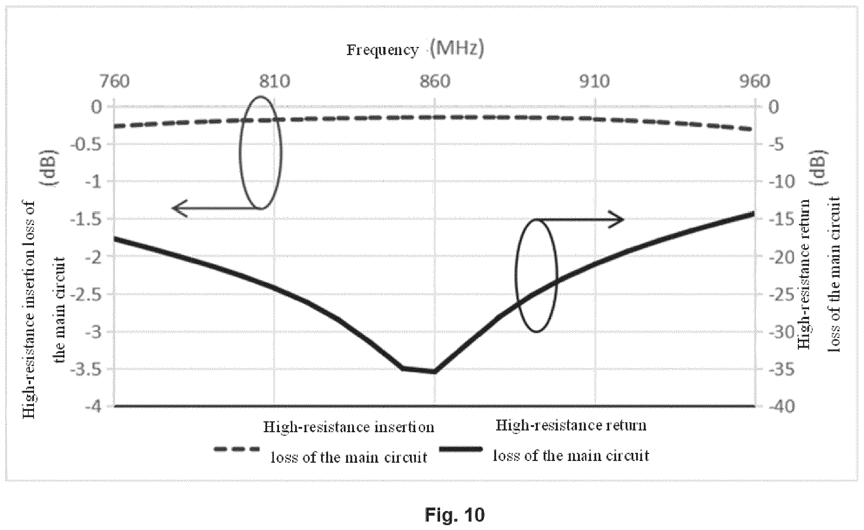

The following is an example of a DHT amplifier with a chip structure shown in Fig. 6 and a center frequency of 860 MHz to illustrate the technical effect of the present disclosure. As shown in Fig. 10, Fig. 10 is a simulation data diagram of the power amplifier corresponding to Fig. 6, the dotted line represents the high-resistance insertion loss of the main circuit, that is, the insertion loss of the first amplifying branch in the fallback state. The smaller the loss, the greater the bandwidth. The solid line represents the high-resistance return loss of the main circuit, that is, the return loss of the first amplifier branch in the fallback state. The smaller the value, the better the matching quality and the larger the bandwidth. It can be seen that the chip structure shown in Fig. 6 has good bandwidth characteristics.

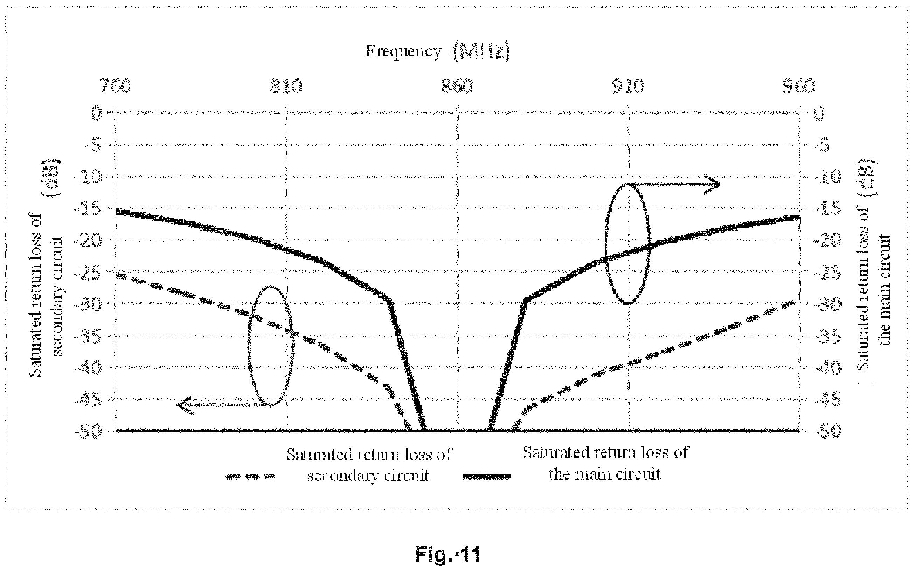

As shown in Fig. 11, Fig. 11 is another simulation data diagram of the power amplifier corresponding to Fig. 6. The solid line represents the saturated return loss of the main circuit, that is, the return loss of the first amplifying branch in the saturated state. The dotted line represents the saturated return loss of the secondary circuit, that is, the return loss of the second amplifying branch in the saturated state. The smaller the value, the better the matching quality and the larger the bandwidth. It can be seen that the chip structure shown in Fig. 6 has good bandwidth characteristics.

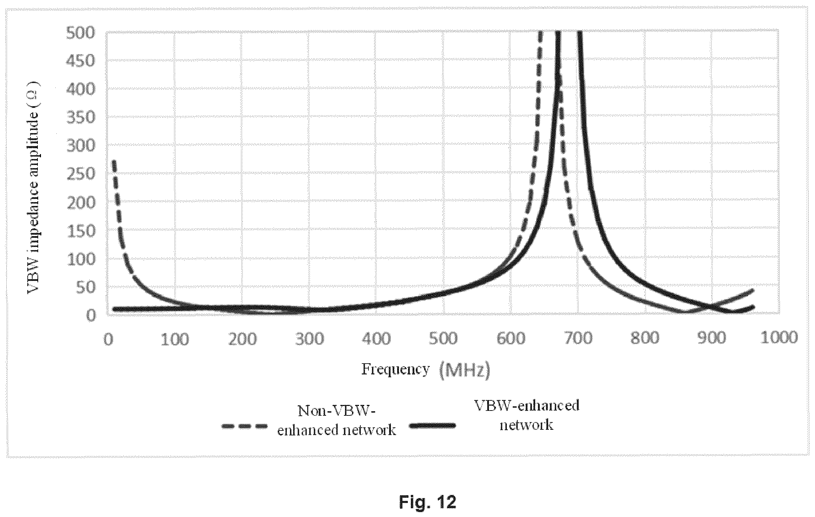

As shown in Fig. 12, Fig. 12 is yet another simulation data diagram of the power amplifier corresponding to Fig. 6. The solid line represents a VBW (video bandwidth) impedance increase in a VBW-enhanced network state, and the dotted line represents a VBW impedance increase in a non-VBW-enhanced network state. As can be seen from Fig. 14, after adding the VBW-enhanced network, the frequency below 400 MHz is very flat, indicating that the response of the VBW impedance is very consistent.

A Doherty amplifier with the first output circuit having an electrical length of 90 degrees and the second output circuit having an electrical length of 180 degrees is designed as an example.

1. The drain voltage of the first transistor and the second transistor is VDD and the knee voltage is Vknee, which determines the voltage swing of the process. The power normalized drain-source capacitance of the first transistor and the second transistor is also clear to be Cds_per_W Also, for a specific disclosure scenario, the saturation power is clear to be Psat, and the operating frequency is also clear to be fo. Therefore, for the Doherty amplifier, the optimal load at the combining point can be calculated as follows:

$$R_L = \frac{(VDD - Vknee)^2}{2 \cdot Psat}$$

2. Also assuming that the power ratio of the first amplifying branch and the second amplifying branch is saturated is $\alpha$, the optimal load in the saturated state of the first amplifying branch and the second amplifying branch can be calculated, and the high resistance load in the fallback state of the first amplifying branch can be calculated as follows:

$$R_{opt\_M} = R_L \cdot (1 + \alpha)$$

$$R_{opt\_P} = R_L \cdot \frac{(1 + \alpha)}{\alpha}$$

$$R_{RHL\_M} = R_L \cdot (1 + \alpha)^2$$

3. The second output circuit comprises a first sub-output circuit and a second sub-output circuit, whereby the characteristic impedances of the first output circuit TL1 in the first amplifying branch, the first sub-output circuit TL2 in the second amplifying branch, and the second sub-output circuit TL3 in the second amplifying branch can be obtained as follows:

$$Z_{TL1} = R_{opt\_M}$$

$$Z_{TL2} = Z_{TL3} = R_{opt\_P}$$

4. According to the saturation power Psat, the power ratio $\alpha$, and the power normalized drain-source capacitance Cds_per W, the values of the parasitic capacitor Cds of the first amplifying branch and the second amplifying branch can be calculated as follows:

$$CdsM = \frac{Psat}{1 + \alpha} \cdot Cds\_per\_W$$

$$CdsP = \frac{\alpha \cdot Psat}{1 + \alpha} \cdot Cds\_per\_W$$

5. With the corresponding parasitic capacitor Cds and characteristic impedance ZTL, the conversion of each segment of the output circuit can be started. In Fig. 2, whether a capacitor or an inductor is connected between the first inductor L1 and the second inductor L2 in the first output circuit, is determined by: $Q1 = 2\pi \cdot fo \cdot Z_{TL1} \cdot CdsM$. In a case where the value of Q1 is less than 1, it is a capacitor, and in a case where Q1 is greater than 1, it is an inductor. In Fig. 6, whether a capacitor or an inductor is connected between the fourth inductor L4 and the fifth inductor L5 in the second sub-output circuit, is determined by: $Q2 = 2\pi \cdot fo \cdot Z_{TL1} \cdot CdsP$. In a case where the value of Q2 is less than 1, it is a capacitor, and in a case where Q2 is greater than 1, it is an inductor.

The connection between the first inductor L1 and second inductor L2 is the same as between the fourth inductor L4 and fifth inductor L5, as can be seen from the following expansions of Q$1$ of the first amplifying branch and Q2 of the second amplifying branch:

$$Q1 = 2\pi \cdot fo \cdot Z_{TL1} \cdot CdsM = 2\pi \cdot fo \cdot (VDD - Vknee)^2 \cdot Cds\_per\_W$$

$$Q2 = 2\pi \cdot fo \cdot Z_{TL2} \cdot CdsP = 2\pi \cdot fo \cdot (VDD - Vknee)^2 \cdot Cds\_per\_W$$

Then the components in Fig. 2 are as follows:

$$L_1 = L_2 = \frac{Z_{TL1}}{2\pi \cdot fo \cdot (1 + Q1)}$$

$$L_3 = \frac{Z_{TL1}}{2\pi \cdot fo \cdot (Q1^2 - 1)}$$

$$C_2 = CdsM + \frac{1}{2\pi \cdot fo \cdot Z_{TL3}}$$

$$Cds1 = CdsM$$

$$L_4 = L_5 = \frac{Z_{TL2}}{2\pi \cdot fo \cdot (1 + Q2)}$$

$$L_6 = \frac{Z_{TL3}}{2\pi \cdot fo}$$

$$L_7 = \frac{Z_{TL2}}{2\pi \cdot fo \cdot (Q2^2 - 1)}$$

$$C_1 = \frac{1}{2\pi \cdot fo \cdot Z_{TL3}} + CdsP$$

$$Cds2 = CdsP$$

Then the components in Fig. 6 are as follows:

$$L_1 = L_2 = \frac{Z_{TL1}}{2\pi \cdot fo \cdot (1 + Q1)}$$

$$L_3 = \frac{Z_{TL1}}{2\pi \cdot fo \cdot (Q1^2 - 1)}$$

$$C_2 = CdsM + \frac{1}{2\pi \cdot fo \cdot Z_{TL3}}$$

$$Cds1 = CdsM$$

$$C_5 = \frac{(1 - Q1^2)}{2\pi \cdot fo \cdot Z_{TL1}}$$

$$L_4 = L_5 = \frac{Z_{TL2}}{2\pi \cdot fo \cdot (1 + Q2)}$$

$$L_6 = \frac{Z_{TL3}}{2\pi \cdot fo}$$

$$C_6 = \frac{(1 - Q2^2)}{2\pi \cdot fo \cdot Z_{TL2}}$$

$$C_1 = \frac{1}{2\pi \cdot fo \cdot Z_{TL3}} + CdsP$$

$$Cds2 = CdsP$$

The present disclosure also provides a wireless signal transmitting system comprising the aforementioned radio frequency power amplifier, a radio frequency output device (not shown), and a signal transmitting device. The radio frequency power amplifier is respectively connected to the radio frequency output device and the signal transmitting device. The radio frequency output device outputs the radio frequency signal to the radio frequency power amplifier. The radio frequency power amplifier amplifies the received signal and then outputs it to the signal transmitting device. The signal transmitting device transmits the signal to the user terminal.

In the description of the present disclosure, it is to be understood that the terms "first", "second", "third", etc. are for descriptive purposes only, and cannot be understood as indicating or implying relative importance or implying the number of indicated technical features. Thus, the features defined as "first", "second", "third" and the like may expressly or implicitly comprise one or more of the features. In the description of the disclosure, "a plurality of" means at least two, e.g. two, three, etc., unless otherwise expressly and specifically qualified.

In the disclosure, unless otherwise expressly stipulated and qualified, the terms "connected", "disposed" and other terms should be understood in a broad sense, for example, it can be a fixed connection or a detachable connection. It can be directly connected or indirectly connected through an intermediate medium. For those of ordinary skill in the art, the specific meanings of the above-mentioned terms in the disclosure can be understood on a case-by-case basis.

Obviously, one skilled in the art can make various modifications and variations to the disclosure without departing from the spirit and scope of the disclosure. Thus, to the extent that these modifications and variations of the disclosure fall within the scope of the claims in the disclosure and their equivalent techniques, the disclosure is intended to comprise these modifications and variations as well.

**Claims**

1. A radio frequency power amplifier, for connecting to a radio frequency output device and a signal transmitting device, comprising:

  a first amplifying branch (101), comprising a first transistor (1012) and a first output circuit (1013), a gate of the first transistor (1012) connected to the radio frequency output device, a drain of the first transistor (1012) connected to a first end of the first output circuit (1013), and a second end of the first output circuit (1013) connected to the signal transmitting device (103); and

  a second amplifying branch (102), comprising a second transistor (1022) and a second output circuit (1023), a gate of the second transistor (1022) connected to the radio frequency output device, a drain of the second transistor (1022) connected to a first end of the second output circuit (1023), and a second end of the second output circuit (1023) connected to the signal transmitting device (103);

  wherein the first output circuit (1013) comprises a line with an electrical length of 50 degrees to 90 degrees formed based on capacitors and inductors, and the second output circuit (1023) comprises a line with an electrical length of 120 degrees to 180 degrees formed based on capacitors and inductors.

2. The radio frequency power amplifier according to claim 1, wherein the first output circuit (1013) comprises:

  a first inductor (L1), having a first end connected to the drain of the first transistor (1012);

  a second inductor (L2), having a first end connected to a second end of the first inductor (L1) and a second end connected to the signal transmitting device (103);

  a third inductor (L3), having a first end connected between the second end of the first inductor (L1) and the first end of the second inductor (L2);

  a first decoupling capacitor (CRF1), having a first end connected to a second end of the third inductor (L3) and a second end grounded; and

  a second capacitor (C2), having a first end connected to the second end of the second inductor (L2) and a second end grounded;

  or

  wherein the second output circuit (1023) comprises:

  a fourth inductor, having a first end connected to the drain of the second transistor (1022);

  a fifth inductor, having a first end connected to a second end of the fourth inductor;

  a sixth inductor, having a first end connected to a second end of the fifth inductor and a second end connected to the signal transmitting device (103);

  a seventh inductor, having a first end connected between a second end of the fourth inductor and the first end of the fifth inductor;

  a second decoupling capacitor, having a first end connected to a second end of the seventh inductor and a second end grounded; and

  a first capacitor, having a first end connected between the second end of the fifth inductor and the first end of the sixth inductor and a second end grounded;

  wherein the first transistor (1012) comprises a first parasitic capacitor and the second transistor (1022) comprises a second parasitic capacitor.

3. The radio frequency power amplifier according to claim 2, wherein the first output circuit (1013) further comprises:

  a first resistor, having a first end connected between the second end of the third inductor (L3) and the first end of the first decoupling capacitor (CRF1); and

  a third capacitor, having a first end connected to a second end of the first resistor and a second end grounded;

  or

  wherein the second output circuit (1023) further comprises:

  a second resistor, having a first end connected between the second end of the seventh inductor and the first end of the second decoupling capacitor; and

  a fourth capacitor, having a first end connected to a second end of the second resistor and a second end grounded.

4. The radio frequency power amplifier according to claim 2, further comprising:

a first drain power supply circuit, having a first end connected between the second end of the third inductor (L3) and the first end of the first decoupling capacitor (CRF1) and a second end connected to a first power supply; or
a second drain power supply circuit, having a first end connected between the second end of the seventh inductor and the first end of the second decoupling capacitor and a second end connected to a second power supply.

5. The radio frequency power amplifier according to claim 1, wherein the first amplifying branch (101) further comprises:

a first inductor (L1), having a first end connected to the drain of the first transistor (1012);
a second inductor (L2), having a first end connected to a second end of the first inductor (L1) and a second end connected to the signal transmitting device (103);
a fifth capacitor, having a first end connected between the second end of the first inductor (L1) and the first end of the second inductor (L2) and a second end grounded; and
a second capacitor (C2), having a first end connected to the second end of the second inductor (L2) and a second end grounded;
or
wherein the second output circuit (1023) comprises:

a fourth inductor (L4), having a first end connected to the drain of the second transistor (1022);
a fifth inductor (L5), having a first end connected to a second end of the fourth inductor (L4);
a sixth inductor (L6), having a first end connected to a second end of the fifth inductor (L5) and a second end connected to the signal transmitting device (103);
a sixth capacitor (C6), having a first end connected between the second end of the fourth inductor (L4) and the first end of the fifth inductor (L5) and a second end grounded; and
a first capacitor (C1), having a first end connected between the second end of the fifth inductor (L5) and the first end of the sixth inductor (L6) and a second end grounded;
wherein the first transistor (1012) comprises a first parasitic capacitor (Cds1) and the second transistor (1022) comprises a second parasitic capacitor (Cds2).

6. The radio frequency power amplifier according to claim 2 or 4, further comprising:

an eighth inductor (L8), having a first end connected to the second end of the second inductor (L2) and the second end of the sixth inductor (L6) respectively;
a third resistor (R3), having a first end connected to a second end of the eighth inductor (L8);
a third decoupling capacitor (CRF3), having a first end connected between the second end of the eighth inductor (L8) and the first end of the third resistor (R3) and a second end grounded; and
a seventh capacitor (C7), having a first end connected to the second end of the third resistor (R3) and a second end grounded.

7. The radio frequency power amplifier according to claim 6, further comprising:
a third drain power supply circuit, having a first end connected between the second end of the eighth inductor (L8) and the first end of the third resistor (R3) and a second end connected to a third power supply (307).

8. The radio frequency power amplifier according to any one of claims 1 to 7, further comprising:
a power distributor (210), having an input terminal connected to the radio frequency output device, a first output terminal connected to the gate of the first transistor (1012), and a second output terminal connected to the gate of the second transistor (1022).

9. The radio frequency power amplifier according to claim 8, further comprising:

a first gate bias circuit, having a first end connected to the gate of the first transistor (1012) and a second end connected to a fourth power supply (305);
or
a second gate bias circuit, having a first end connected to the gate of the second transistor (1022) and a second end connected to a fifth power supply (306).

10. The radio frequency power amplifier according to claim 9, further comprising:

a first DC-blocking capacitor (201), having a first end connected to the first output terminal of the power distributor (210) and a second end connected to the gate of the first transistor (1012) and the first end of the first gate bias circuit respectively;

or

a second DC-blocking capacitor (202), having a first end connected to the second output terminal of the power distributor (210) and a second end connected to the gate of the second transistor (1022) and the first end of the second gate bias circuit respectively.

11. A wireless signal transmitting system, comprising:

a radio frequency output device and a signal transmitting device (103); and
the radio frequency power amplifier according to any one of claims 1 to 10, the radio frequency power amplifier connected to the radio frequency output device and the signal transmitting device (103) respectively.

First amplifying branch
101

First
transistor
1012

First transmission line
1011

Second transmission
line 1021

Second
transistor
1022

Second amplifying branch
102

Fig. 1

Fig. 2

Fig. 3

Fig. 4

**Fig. 5**

Fig. 6

**Fig. 7**

**Fig. 8**

Fig. 9

Fig. 10

High-resistance insertion
--- loss of the main circuit

High-resistance return
— loss of the main circuit

**Fig.·11**

**Fig. 12**

Europäisches
Patentamt
European
Patent Office
Office européen
des brevets

# EUROPEAN SEARCH REPORT

**Application Number**

EP 24 18 9792

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/391829 A1 (SRINIDHI EMBAR RAMANUJAM [US] ET AL) 16 December 2021 (2021-12-16) * paragraphs [0007], [0048], [0051], [0073], [0078]; figures 1,2 * | 1-11 | INV. H03F1/02 H03F1/56 H03F3/195 H03F3/21 H03F3/24 |
| X | US 2016/006399 A1 (BLEDNOV IGOR [FR]) 7 January 2016 (2016-01-07) * paragraph [0001]; claims 8,9; figures 1,2a,4,5 * | 1,11 | |
| A | | 2-10 | |
| A | US 2021/376798 A1 (SRINIDHI EMBAR RAMANUJAM [US] ET AL) 2 December 2021 (2021-12-02) * paragraphs [0015], [0024] - [0036]; figures 1,2,6,7 * | 1-11 | |

TECHNICAL FIELDS
SEARCHED      (IPC)

H03F

The present search report has been drawn up for all claims

| Place of search | Date of completion of the search | Examiner |
|---|---|---|
| The Hague | 6 January 2025 | Zakharian, Andre |

EPO FORM 1503 03.82 (P04C01)

## ANNEX TO THE EUROPEAN SEARCH REPORT
## ON EUROPEAN PATENT APPLICATION NO.

EP 24 18 9792

This annex lists the patent family members relating to the patent documents cited in the above-mentioned European search report.
The members are as contained in the European Patent Office EDP file on
The European Patent Office is in no way liable for these particulars which are merely given for the purpose of information.

06-01-2025

| Patent document cited in search report | Publication date | Patent family member(s) | Publication date |
|---|---|---|---|
| US 2021391829 A1 | 16-12-2021 | NONE | |
| US 2016006399 A1 | 07-01-2016 | US 2016006399 A1<br>WO 2014108716 A1 | 07-01-2016<br>17-07-2014 |
| US 2021376798 A1 | 02-12-2021 | NONE | |

EPO FORM P0459

For more details about this annex : see Official Journal of the European Patent Office, No. 12/82